# EUROPEAN PATENT SPECIFICATION

(11) **EP 0 450 494 B1**
(45) Date of publication and mention of the grant of the patent: **19.06.1996**
(21) Application number: 91104896.5
(22) Date of filing: 27.03.1991
(51) Int. Cl.: C30B 13/00, C30B 29/06

(54) **Manufacturing method for single-crystal silicon**
Verfahren zur Herstellung eines Siliziumeinkristalles
Procédé de fabrication de monocristaux de silicium

(30) Priority: 30.03.1990 JP 85193/90
(43) Date of publication of application: 09.10.1991
(73) Proprietor: SUMITOMO SITIX CORPORATION, Hyogo (JP)
(72) Inventor: Kaneko, Kyojiro, Ibaraki, Osaka (JP); Mizumoto, Hideyuki, Kadoma, Osaka (JP); Misawa, Teruoki, Takarazuka, Hyogo (JP)
(74) Representative: Wächtershäuser, Günter, Prof. Dr.

(56) References cited:
- DE-A- 3 220 340
- DE-A- 3 333 960
- GB-A- 898 872
- PATENT ABSTRACTS OF JAPAN, vol. 14, no. 184 (C-709)[4127], 13th April 1990; & JP-A-2 30 698 (OSAKA TITANIUM CO., LTD) 01-02-1990
- PATENT ABSTRACTS OF JAPAN, vol. 14, no. 220 (C-717)[4163], 10th May 1990; & JP-A-251493 (OSAKA TITANIUM CO., LTD) 21-02-1990

## Description

### DETAILED DESCRIPTION OF THE INVENTION

### (Field of the Invention)

The present invention relates to a manufacturing method for single-crystal silicon used for an element for semiconductors, solar batteries and the like.

### (Background of the Invention)

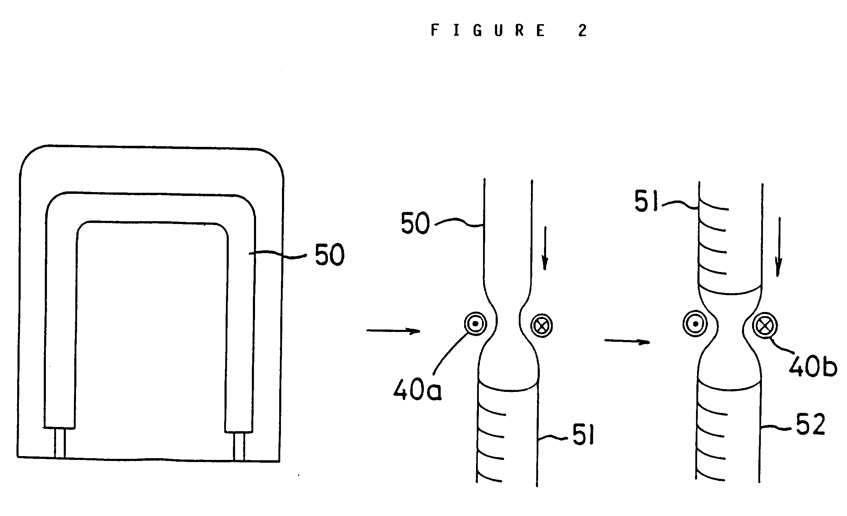

A single-crystal material, in particular, single-crystal silicon in a large size is an essential element for development of highly effective solar batteries. A single-crystal silicon rod obtained by FZ method is appreciated to have highest quality among others at present since CZ method corresponding to FZ method for providing single-crystal silicon cannot eliminate the defect caused by admixed oxygen due to use of a crucible. Fig. 2 shows a manufacturing method for a single-crystal silicon rod according to FZ method.

The conventional manufacturing method for a single-crystal silicon rod in accordance with FZ method uses as an element a polycrystalline silicon rod 50 manufactured by Siemens process and partially melts and inserts the element into an induction coil 40a to form a single-crystal silicon rod 51 which is further inserted into an induction coil 40b to provide the product of a single-crystal silicon rod 52. FZ melting in twice are required to fully exhaust gas contained in the element, the polycrystalline silicon rod 50 as instructed in manufacturing manuals published by the makers which develop and practically use FZ method.

### (Problems that the invention solves)

The conventional method provides a single-crystal silicon rod of a long lifetime, high specific resistance and the like each essential for the solar batteries, but a high cost and price for production by the conventional method hinder provision of the element in a large size for the solar batteries. Reasons for the high cost to produce the single-crystal silicon rod by FZ method are mainly as follows.
(1) A high cost to produce by Siemens process for providing the element, the polycrystalline silicon rod.
(2) High loss that a polycrystalline silicon rod manufactured by Siemens process is poor in accuracy of outer diameter, so that the outer surface of the rod requires to be cut much for the FZ melting.
(3) Necessity of the FZ melting in twice.

An object of the present invention is to provide a manufacturing method for single-crystal silicon for providin the single-crystal silicon of quality equivalent to that obtained by the conventional FZ method an a largely lower cost.

### (Means that solves the problems)

Siemens process has been widely put in use at present for manufacturing a polycrystalline silicon rod and is conducted basically in batch production to thereby be low in production efficiency. Siemens process has problems also in that the surface area for deposition of silicon is smaller with respect to the furnace capacity and the furnace surface dissipates heat largely, thereby leading to a high cost to produce. In recent years, the fluidized-bed granulation process in place of Siemens process has been given attention as a manufacturing method for crystalline silicon and the applicant has developed this process (Japanese Patent Applications Nos. 324010/1988, 100929/1989, 100930/1989 and the like).

The fluidized-bed granulation process continuously grows polycrystalline silicon granules in fluidized-bed reactor (FBR) and extracts them therefrom, so that the process is substantially high in production efficiency in comparison with Siemens process in batch production, and a ratio of the surface area for deposition of silicon with respect to the capacity of FBR is especially larger, thereby providing definite advantages in productivity, efficiency of power consumption and the like, and a notably lower cost to produce in comparison with Siemens process.

In addition to the aforesaid manufacturing method of polycrystalline silicon by the fluidized-bed granulation process, the applicant has also studied a manufacturing method for single-crystal silicon by a continuous casting through electromagnetic induction, and found that a combination of the fluidized-bed granulation process, the continuous casting through electromagnetic induction and FZ method provides a quite reasonable and economical manufacturing method for single-crystal silicon of high quality.

A cheap silicon material for solar batteries manufactured by carbon reduction process has been studied in recent years. When the method is put into practical use, crushed product of the silicon material can also be useable.

A manufacturing method for single-crystal silicon of the present invention is characterized in that a polycrystalline silicon rod manufactured by a continuous casting through electromagnetic induction and by using as raw material polycrystalline silicon granules is single-crystallized by FZ method.

### (Effect of the Invention)

The continuous casting method through electromagnetic induction disposes in an induction coil a bottomless conductive crucible circumferentially divided at at least a part in the axial direction thereof to melt raw material in the bottomless crucible and pull down therefrom the molten raw material being solidified to form an elongated rod. In this method, raw material in the bottomless crucible does not contact with an inner surface of the crucible, so that the method when used for manufacturing a polycrystalline silicon rod exhibits an advantage to fully prevent contamination of the silicon rod by the bottomless crucible.

The United States of America has filed a patent application in Japan for a manufacturing method for polycrystalline silicon by using the continuous casting through electromagnetic induction on the basis of the above concept (Japanese Unexamined Patent Application No. 52962/1986) and the applicant of the present invention has continuously studied this method for industrialization (Japanese Unexamined Patent Applications Laid Open Nos. 264920/1989 and 30698/1990).

The combination of granular silicon material, the continuous casting method through electromagnetic induction and FZ method manufactures at a low cost a polycrystalline silicon rod for FZ method with high quality, and also provides through once of FZ melting of polycrystalline silicon rod a single-crystal silicon rod of very high quality equivalent to that obtained by FZ melting in twice of polycrystalline silicon rod manufactured by the conventional Siemens process. In addition, the polycrystalline silicon rod when provided for FZ method does not require to be largely cut at its outer surface as required in polycrystalline silicon rod manufactured by Siemens process. Hence, a single-crystal silicon rod of very high quality can be manufactured at a notably low cost.

### (Embodiments of the Invention)

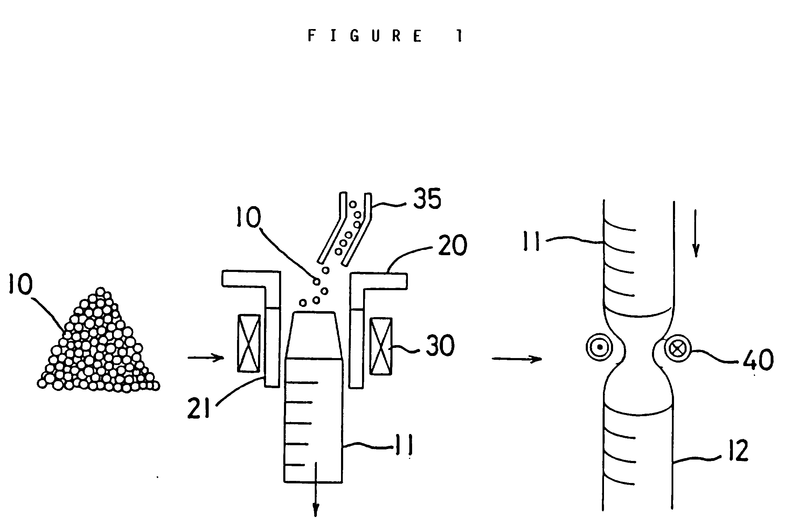

Next, explanation will be given on an embodiment of the present invention. The manufacturing method for single-crystal silicon of the present invention uses as raw material polycrystalline silicon granules 10 upon conducting the continuous casting through electromagnetic induction as shown in Fig. 1.

The method of continuous casting through electromagnetic induction itself is as disclosed, for example, in Japanese Unexamined Patent Applications Laid Open Nos. 264920/1989, 30698/1990 and the like. In brief, a cylindrical bottomless crucible 20 and induction coils 30 are disposed in vacuum chamber (not shown). The bottomless crucible 20 may use, for example, a water-cooled copper crucible circumferentially divided at the body except the upper end portion. The induction coils 30 are fit onto the outer periphery of the bottomless crucible 20 at the divided parts 21 in a manner of being coaxially and spaced with each other. Polycrystalline silicon granules 10 fed into the bottomless crucible 20 through a hopper 35 are molten in the state of no contact with the inner surface of the crucible 20. Feeding of raw material into the bottomless crucible 20 and pulling down of molten raw material which being solidified from the crucible are continued to manufacture a polycrystalline silicon rod 11 (unidirectionally solidified cast block of silicon).

An outer diameter of the polycrystalline silicon rod 11 manufactured is decided by an inner diameter of the bottomless crucible 20, so that the polycrystalline silicon rod has uniform outer diameter over the total length. Hence, the outer surface of the rod is only cut slightly to allow the rod to have a required outer diameter for FZ melting. In the FZ melting, the polycrystalline silicon rod 11 with finished outer surface is fit through an induction coil 40 to form a single-crystal silicon rod 12.

The polycrystalline silicon granules 10 manufactured by the fluidized-bed granulation process are almost half in price at present in comparison with a polycrystalline silicon rod manufactured by Siemens process and the price is expected to further lower following realization of practical use of silicon for solar batteries manufactured by carbon reduction process. A cost to produce polycrystalline silicon rod 11 including a cost for the continuous casting through electromagnetic induction may be controlled to a degree of a cost to produce by Siemens process.

In addition, the polycrystalline silicon rod 11 manufactured by the continuous casting through electromagnetic induction and by using as raw material polycrystalline silicon granules 10 is of higher quality than a polycrystalline silicon rod manufactured by Siemens process, and a single-crystal silicon rod of quality equivalent to that obtained by FZ melting of Siemens rod in twice can be ensured by once of FZ melting. Furthermore, the polycrystalline silicon rod 11 is higher in accuracy of outer diameter in comparison with Siemens rod, quite small extent of the outer surface portion of the rod is enough to be cut for application of the rod to FZ melting, and once of FZ melting is enough for obtaining the single-crystal silicon rod of high quality, so that the price of the single-crystal silicon rod 12 can be notably reduced.

Table 1 shows comparison between the present invention and the conventional method with respect to a cost and quality of a single-crystal silicon rod of 12,7 cm (5 ins). in outer diameter manufactured by the methods. Requirements for manufacturing by the present invention are shown in Table 2.

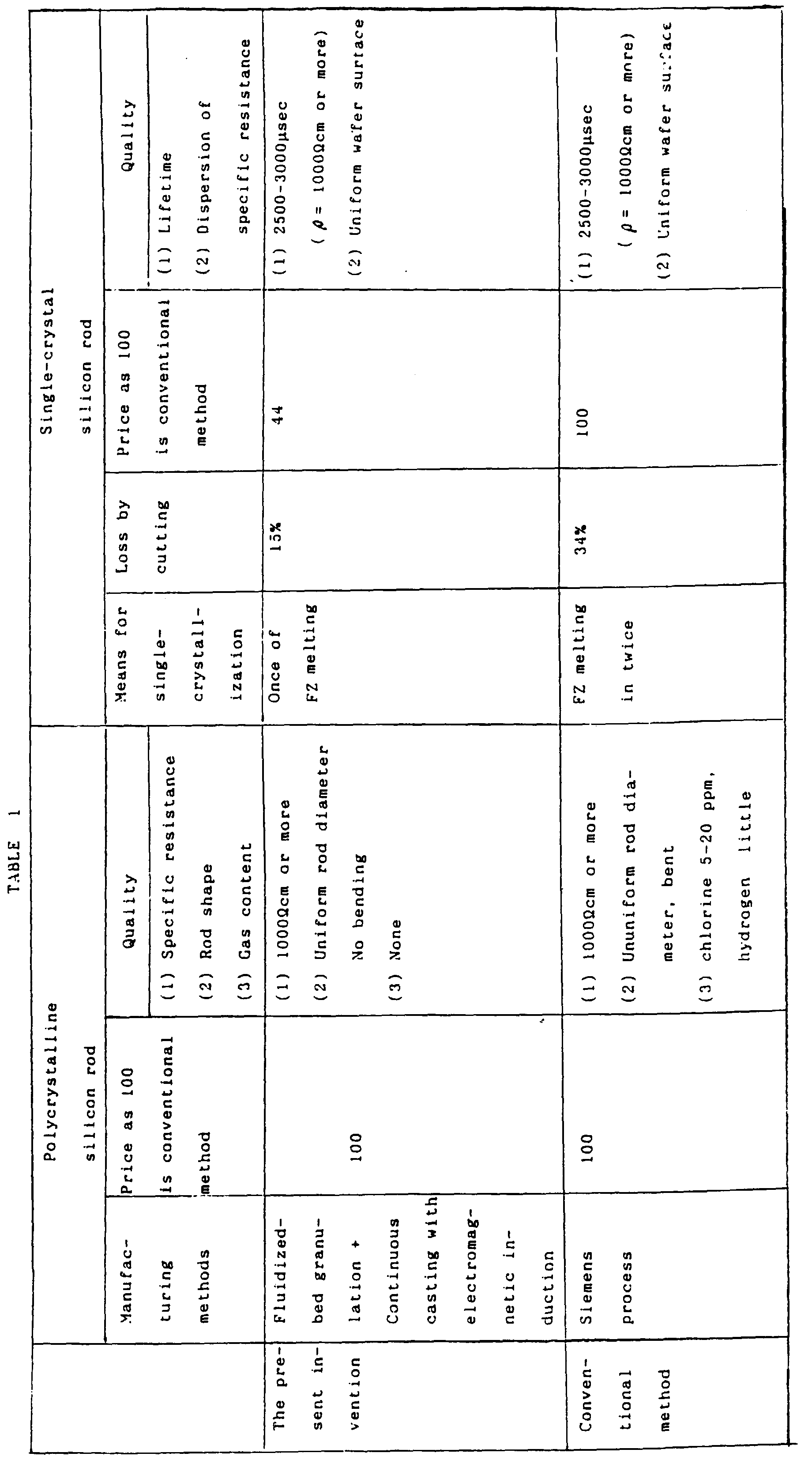

**TABLE 2**

| | | |
|---|---|---|
| Requirements for electromagnetic casting | Particles diameter of granules material | 1 to 3 mm |
| | Diameter of ingot | 12.7 cm (5 ins.) |
| | Length of ingot | 200 cm |
| | Pull velocity | 3.0 mm/min |
| | Power dissolution output | 85 kw |
| | Ar pressure | 1.05 atmosphere |
| Requirements for FZ melting | Diameter of ingot | 12.7 cm (5 ins.) |
| | Length of ingot | 100 cm |
| | Pull velocity | 2.0 mm/min |
| | The number of rotation | 6 Rpm |
| | Power frequency | 2 MHz |
| | Ar pressure | 1.05 atmosphere |

As seen in Table 1, the polycrystalline silicon rod manufactured by the invention has high quality achieved by once of FZ melting and equivalent to that obtained by the conventional FZ melting in twice, so that the invention is apparently economical in comparison with the conventional method. Reasons that the polycrystalline silicon rod of the present invention has high quality are appreciated as follows.

Siemens process conducts deposition of silicon through gas phase reaction, so that reaction product such as chlorine and hydrogen may be taken into the silicon rod in trace quantity. The gas content volatilizes in gas phase as bumping gas upon a first FZ melting of silicon rod to agitate a stable condition of silicon melt molten in zones and disturb growth of single-crystal silicon of high quality. A polycrystalline silicon rod by electromagnetic casting previously dissipates all gas content to volatilize in the first melting upon electromagnetic casting, so that it has no factors to disturb the stable holding of the silicon melt upon FZ melting. Hence, a polycrystalline silicon rod by electromagnetic casting when subjected to once of FZ melting can grow single-crystal silicon of high quality.

### (Effects of the Invention)

As seen from the above, the manufacturing method for single-crystal silicon of the present invention provides such advantages that it is notably economical and ensures enough quality of the single-crystal silicon for an element for highly effective solar batteries and the like, thereby largely contributing to development of highly effective solar batteries and the like.

### 4. BRIEF DESCRIPTION OF THE DRAWINGS

Fig. 1 is a schematic diagram showing the steps of practical use of the present invention, and Fig. 2 is a schematic diagram showing the conventional method.
10: Polycrystalline silicon granules, 11: Polycrystalline silicon rod, 12: Single-crystal silicon rod, 20: Bottomless crucible, 30, 40: Inducticn coil.

## Claims

1. A manufacturing method for single-crystal silicon, characterized in that a polycrystalline silicon rod manufactured by a continuous casting through electromagnetic induction and by using as raw material polycrystalline silicon granules is single-crystallized by FZ method.

2. A manufacturing method for single-crystal silicon as set forth in claim 1, wherein polycrystalline silicon granules are manufactured by fluidized-bed granulation process.

## Patentansprüche

1. Herstellverfahren für einkristallines Silizium, **dadurch gekennzeichnet, daß** ein durch kontinuierliches Gießen mittels elektromagnetischer Induktion und unter Verwendung polykristalliner Siliziumkörner als Ausgangsmaterial hergestellter polykristalliner Siliziumstab durch das FZ-Verfahren zu einem Einkristall ausgebildet wird.

2. Herstellverfahren für einkristallines Silizium nach Anspruch 1, bei dem polykristalline Siliziumkörner durch einen Fließbett-Granulatprozeß hergestellt werden.

## Revendications

1. Procédé de fabrication de silicium monocristal, caractérisé en ce qu'une barre de silicium polycristallin, fabriquée par une coulée continue par induction électromagnétique et par utilisation, comme matière première, de granulés de silicium polycristallin, est soumise à une monocristallisation par le procédé FZ.

2. Procédé de fabrication de silicium monocristal selon la revendication 1, dans lequel les granulés de silicium polycristallin sont fabriqués par un procédé de granulation en lit fluidisé.
